# EUROPEAN PATENT APPLICATION

(11) **EP 4 421 945 A1**
(43) Date of publication of application: **28.08.2024**
(21) Application number: 21961701.6
(22) Date of filing: 26.10.2021
(51) Int. Cl.: H01M 10/44, H01M 10/42

(54) **ELECTROCHEMICAL DEVICE MANAGEMENT METHOD, SYSTEM, ELECTROCHEMICAL DEVICE, AND ELECTRONIC APPARATUS**

(71) Applicant: DONGGUAN POWERAMP TECHNOLOGY LIMITED, Dongguan, Guangdong 523000 (CN); Ningde Amperex Technology Limited, Ningde, Fujian 352100 (CN)
(72) Inventor: CHENG, Yarui, Dongguan, Guangdong 523000 (CN); WANG, Huixin, Dongguan, Guangdong 523000 (CN); CHEN, Yingjie, Dongguan, Guangdong 523000 (CN); ZHEN, Jieming, Dongguan, Guangdong 523000 (CN)
(74) Representative: Icosa
(86) International application number: PCT/CN2021/126458
(87) International publication number: WO 2023/070325

(57) **Abstract**

An electrochemical apparatus management method, the method includes: performing a first charge-discharge cycle on an electrochemical apparatus at a charge current; performing an intermittent charge operation on the electrochemical apparatus at a detection current, obtaining data related to the electrochemical apparatus in the intermittent charge operation, and determining a lithium precipitation SOC of the electrochemical apparatus based on the data related to the electrochemical apparatus; and in response to the lithium precipitation SOC of the electrochemical apparatus being higher than a first SOC threshold, performing a second charge-discharge cycle on the electrochemical apparatus at the charge current, or in response to the lithium precipitation SOC of the electrochemical apparatus being lower than or equal to the first SOC threshold, controlling the electrochemical apparatus to perform a risk control operation..

## Description

### TECHNICAL FIELD

This application relates to the field of electrochemistry technologies, and specifically, to an electrochemical apparatus management method, a system, an electrochemical apparatus, and an electronic device.

### BACKGROUND

Lithium-ion batteries have many advantages such as large specific energy density, long cycle life, high nominal voltage, low self-discharge rate, small volume, and light weight, and therefore are widely used in the field of consumer electronics.

In recent years, with the rapid development of consumer electronic products such as tablet computers and mobile phones, the market demand for lithium-ion batteries has also increased. However, during use, lithium-ion batteries undergo lithium precipitation due to side reactions, impact, and other reasons. As a result, batteries are likely to experience short circuits, leading to safety risks and affecting the safety of batteries.

### SUMMARY

Some embodiments of this application are intended to provide an electrochemical apparatus management method, a system, an electrochemical apparatus, and an electronic device, to reduce the risk of lithium precipitation of the electrochemical apparatus during use and improve the safety of the electrochemical apparatus. Specific technical solutions are as follows:

A first aspect of some embodiments of this application provides an electrochemical apparatus management method including: i: performing a first charge-discharge cycle on an electrochemical apparatus at a charge current; ii: performing an intermittent charge operation on the electrochemical apparatus at a detection current, obtaining data related to the electrochemical apparatus in the intermittent charge operation, and determining a lithium precipitation SOC of the electrochemical apparatus based on the data related to the electrochemical apparatus; and iii-1: in response to the lithium precipitation SOC of the electrochemical apparatus being higher than a first SOC threshold, performing a second charge-discharge cycle on the electrochemical apparatus at the charge current, or iii-2: in response to the lithium precipitation SOC of the electrochemical apparatus being lower than or equal to the first SOC threshold, controlling the electrochemical apparatus to perform a risk control operation.

The technical effects of some embodiments of this application are as follows. In some embodiments of this application, the intermittent charge operation is performed on the electrochemical apparatus, the data related to the electrochemical apparatus is obtained in the intermittent charge operation, the lithium precipitation SOC of the electrochemical apparatus is determined based on the related data, and then based on the magnitude relationship between the lithium precipitation SOC and the first SOC threshold, the electrochemical apparatus is controlled to stop operating or the electrochemical apparatus is controlled to perform a risk control operation. This reduces the safety hazards caused when the electrochemical apparatus is still in use after lithium precipitation, thereby improving the safety of the electrochemical apparatus during use.

In an implementation of some embodiments of this application, the electrochemical apparatus management method further includes: repeating step ii and step iii-1 or step iii-2 after step iii-1. In some embodiments of this application, steps ii and step iii-1 or step iii-2 is repeated after step iii-1, allowing lithium precipitation detection analysis to be performed on the electrochemical apparatus throughout the entire life cycle of the electrochemical apparatus, thereby reducing the risk of lithium precipitation of the electrochemical apparatus throughout the entire life cycle.

In an implementation of some embodiments of this application, after step iii-1 or step iii-2, the method further includes: performing a third charge-discharge cycle on the electrochemical apparatus; in response to completing the third charge-discharge cycle, performing the step of performing an intermittent charge operation on the electrochemical apparatus at a detection current, obtaining data related to the electrochemical apparatus in the intermittent charge operation, and determining a lithium precipitation SOC of the electrochemical apparatus based on the data related to the electrochemical apparatus; and in response to the lithium precipitation SOC of the electrochemical apparatus being lower than or equal to a second SOC threshold, controlling the electrochemical apparatus to stop operating, where the second SOC threshold is lower than the first SOC threshold. In some embodiments of this application, after the second charge-discharge cycle or risk control operation is performed on the electrochemical apparatus, when the lithium precipitation SOC of the electrochemical apparatus is lower than or equal to the second SOC threshold, the electrochemical apparatus is controlled to stop operating, thereby improving the safety of the electrochemical apparatus during use.

In an implementation of some embodiments of this application, the electrochemical apparatus is a nickel-cobalt-manganese system electrochemical apparatus, and the second SOC threshold is higher than or equal to 10% and lower than or equal to 30%; or the electrochemical apparatus is a lithium manganate system electrochemical apparatus, and the second SOC threshold is higher than or equal to 20% and lower than or equal to 40%. In some embodiments of this application, different second SOC thresholds are provided for electrochemical apparatuses of different systems, and therefore, times to stop operating can be more accurately determined for the electrochemical apparatuses of different systems, thereby improving the safety of the electrochemical apparatuses of different systems during use.

In an implementation of some embodiments of this application, at least one of the following conditions is satisfied: the number of first charge-discharge cycles is not smaller than the number of second charge-discharge cycles; or the number of second charge-discharge cycles is not smaller than the number of third charge-discharge cycles. In some embodiments of this application, as the number of cycles of the electrochemical apparatus increases, the frequency of determining the lithium precipitation SOC of the electrochemical apparatus can be appropriately increased, thereby improving the safety of the electrochemical apparatus during use.

In an implementation of some embodiments of this application, the number of first charge-discharge cycles is 1 to 500, the number of second charge-discharge cycles is 1 to 100, and the number of third charge-discharge cycles is 1 to 50. In some embodiments of this application, as the number of cycles of the electrochemical apparatus increases, the frequency of determining the lithium precipitation SOC of the electrochemical apparatus can be appropriately increased, thereby improving the safety of the electrochemical apparatus during use.

In an implementation of some embodiments of this application, the data related to the electrochemical apparatus includes an SOC of the electrochemical apparatus and an internal resistance of the electrochemical apparatus, the intermittent charge operation includes multiple charge periods and multiple interruption periods, and the step of obtaining data related to the electrochemical apparatus in the intermittent charge operation, and determining the lithium precipitation SOC of the electrochemical apparatus based on the data related to the electrochemical apparatus includes: in the intermittent charge operation, for each of the multiple interruption periods, obtaining an SOC of the electrochemical apparatus and an internal resistance of the electrochemical apparatus that are corresponding to the interruption period, and obtaining a first curve based on the obtained multiple SOCs of the electrochemical apparatus and the multiple internal resistances of the electrochemical apparatus corresponding to the multiple SOCs, where the first curve is a corresponding mapping curve between the SOCs and internal resistances of the electrochemical apparatus; and determining the lithium precipitation SOC of the electrochemical apparatus based on the first curve.

In an implementation of some embodiments of this application, the step of determining the lithium precipitation SOC of the electrochemical apparatus based on the first curve includes at least one of method 1 or method 2, where method 1 includes: performing a first-order differential on the first curve to obtain a second curve, and determining, as the lithium precipitation SOC, an SOC corresponding to a point at which the second curve first has a negative slope; and method 2 includes: performing a first-order differential on the first curve to obtain a second curve, performing a second-order differential on the second curve to obtain a third curve, and determining, as the lithium precipitation SOC, an SOC corresponding to a point at which the third curve first has a vertical coordinate less than zero.

In an implementation of some embodiments of this application, the intermittent charge operation includes multiple charge periods, each charge cycle includes a charge period and an interruption period, and in each charge cycle, SOC of the electrochemical apparatus increases by a unit amplitude. In some embodiments of this application, the lithium precipitation SOC of the electrochemical apparatus can be determined based on the intermittent charge operation, reducing the risk of lithium precipitation of the electrochemical apparatus.

In an implementation of some embodiments of this application, the electrochemical apparatus includes at least one of lithium iron phosphate system electrochemical apparatus, lithium nickel manganese cobalt system electrochemical apparatus, or lithium cobalt system electrochemical apparatus, where in a case that the electrochemical apparatus is a lithium iron phosphate system electrochemical apparatus, the unit amplitude ranges from 0.5% to 10%, and a duration of the interruption period ranges from 1 second to 15 seconds; in a case that the electrochemical apparatus is a lithium nickel manganese cobalt system electrochemical apparatus, the unit amplitude ranges from 0.5% to 10%, and a duration of the interruption period ranges from 1 second to 30 seconds; or in a case that the electrochemical apparatus is a lithium cobalt system electrochemical apparatus, the unit amplitude ranges from 0.5% to 10%, and a duration of the interruption period ranges from 1 second to 30 seconds. In some embodiments of this application, a more targeted intermittent charge operation can be performed on the electrochemical apparatuses of different systems, so that a more accurate lithium precipitation SOC can be obtained for the electrochemical apparatuses of different systems.

In an implementation of some embodiments of this application, the method satisfies any one of conditions (a) to (f): (a) in a case that the electrochemical apparatus is a lithium iron phosphate system electrochemical apparatus and the electrochemical apparatus is at an ambient temperature of -10°C to 10°C, the unit amplitude ranges from 0.5% to 10%, and a duration of the interruption period ranges from 5 seconds to 15 seconds; (b) in a case that the electrochemical apparatus is a lithium iron phosphate system electrochemical apparatus and the electrochemical apparatus is at an ambient temperature of 10°C to 45°C, the unit amplitude ranges from 0.5% to 10%, and a duration of the interruption period ranges from 1 second to 10 seconds; (c) in a case that the electrochemical apparatus is a lithium nickel manganese cobalt system electrochemical apparatus and the electrochemical apparatus is at an ambient temperature of -10°C to 10°C, the unit amplitude ranges from 0.5% to 10%, and a duration of the interruption period ranges from 10 seconds to 30 seconds; (d) in a case that the electrochemical apparatus is a lithium nickel manganese cobalt system electrochemical apparatus and the electrochemical apparatus is at an ambient temperature of 10°C to 45°C, the unit amplitude ranges from 0.5% to 10%, and a duration of the interruption period ranges from 1 second to 10 seconds; (e) in a case that the electrochemical apparatus is a lithium cobalt system electrochemical apparatus and the electrochemical apparatus is at an ambient temperature of -10°C to 10°C, the unit amplitude ranges from 0.5% to 10%, and a duration of the interruption period ranges from 15 seconds to 30 seconds; or (f) in a case that the electrochemical apparatus is a lithium cobalt system electrochemical apparatus and the electrochemical apparatus is at an ambient temperature of 10°C to 45°C, the unit amplitude ranges from 0.5% to 10%, and a duration of the interruption period ranges from 1 second to 10 seconds. In some embodiments of this application, a more targeted intermittent charge operation can be performed on the electrochemical apparatuses in different ambient environments, so that a more accurate lithium precipitation SOC can be obtained for the electrochemical apparatuses of different systems.

In an implementation of some embodiments of this application, the risk control operation includes at least one of the following: reducing a charge voltage of the electrochemical apparatus, reducing a charge current of the electrochemical apparatus, performing staged charge on the electrochemical apparatus, or generating risk reminder information. In some embodiments of this application, when the lithium precipitation SOC of the electrochemical apparatus is lower than or equal to the first SOC threshold, the electrochemical apparatus is controlled to perform at least one of reducing a charge voltage of the electrochemical apparatus, reducing a charge current of the electrochemical apparatus, performing staged charge on the electrochemical apparatus, or generating risk reminder information, thereby reducing the safety hazards caused when the electrochemical apparatus is still used after lithium precipitation and improving the safety of the electrochemical apparatus during use.

A second aspect of some embodiments of this application provides a system including a processor and a machine-readable storage medium, where the machine-readable storage medium stores a machine-executable instruction capable of being executed by the processor, and when the processor executes the machine-executable instruction, the steps of the method according to any one of the foregoing aspects are implemented.

A third aspect of some embodiments of this application provides an electrochemical apparatus. The electrochemical apparatus includes the system according to the second aspect of some embodiments of this application.

A fourth aspect of some embodiments of this application provides an electronic device. The electronic device includes the electrochemical apparatus according to the third aspect of some embodiments of this application.

According to the electrochemical apparatus management method, the system, the electrochemical apparatus, and the electronic device provided in some embodiments of this application, the intermittent charge operation is performed on the electrochemical apparatus, the data related to the electrochemical apparatus is obtained in the intermittent charge operation, the lithium precipitation SOC of the electrochemical apparatus is determined based on the related data, and then based on the magnitude relationship between the lithium precipitation SOC and the first SOC threshold, the electrochemical apparatus is controlled to stop operating or the electrochemical apparatus is controlled to perform a risk control operation. This reduces the safety hazards caused when the electrochemical apparatus is still in use after lithium precipitation, thereby improving the safety of the electrochemical apparatus during use. Certainly, when any one of the products or methods of some embodiments of this application is implemented, all advantages described above are not necessarily demonstrated simultaneously.

### BRIEF DESCRIPTION OF DRAWINGS

To describe technical solutions in the embodiments of this application and the prior art more clearly, the following briefly describes accompanying drawings required in the embodiments and the prior art. Apparently, the accompanying drawings in the following descriptions show merely some embodiments in this application, and persons of ordinary skill in the art may derive other drawings from these accompanying drawings.
FIG. 1 is a schematic flowchart of an electrochemical apparatus management method according to an embodiment of this application;
FIG. 2 is a schematic diagram of risk reminder information according to an embodiment of this application;
FIG. 3 is a schematic diagram of a first curve according to an embodiment of this application;
FIG. 4 is a schematic diagram of a second curve according to an embodiment of this application;
FIG. 5 is a schematic structural diagram of a system according to an embodiment of this application; and
FIG. 6 is a schematic structural diagram of a system according to another embodiment of this application.

### DESCRIPTION OF EMBODIMENTS

To make the objectives, technical solutions, and advantages of this application more comprehensible, the following describes this application in detail with reference to accompanying drawings and embodiments. Apparently, the described embodiments are merely some but not all of the embodiments of this application. All other embodiments obtained by persons of ordinary skill in the art based on the embodiments of this application falls within the protection scope of this application.

It should be noted that in the content of this application, a lithium-ion battery is used as an example of an electrochemical apparatus to explain this application. However, the electrochemical apparatus of this application is not limited to the lithium-ion battery.

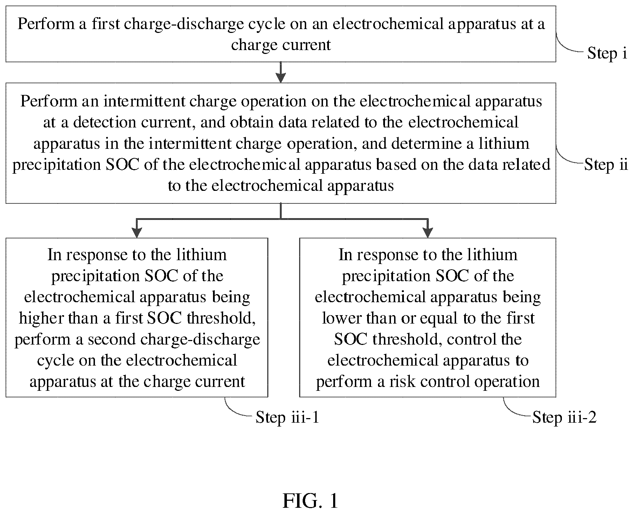

Some embodiments of this application provide an electrochemical apparatus management method. As shown in FIG. 1, the method includes the following steps.

Step i: Perform a first charge-discharge cycle on an electrochemical apparatus at a charge current.

Some embodiments of this application may be executed by a battery management system. During the operation of the electrochemical apparatus, the battery management system can manage the electrochemical apparatus, such as managing the charge and discharge processes of the electrochemical apparatus.

In some embodiments of this application, the battery management system can control the charge current during the charge-discharge cycle process of the electrochemical apparatus. For example, during the operation of the electrochemical apparatus, a charge and discharge apparatus in the battery management system performs a charge-discharge cycle on the electrochemical apparatus at a charge current. The charge-discharge cycle in some embodiments of this application can refer to a cycle of charge, discharge, and charge of the electrochemical apparatus during operation. In the first charge-discharge cycle, the electrochemical apparatus may be charged at the charge current in the charge stage thereof. In addition, the discharge current in the charge-discharge cycle may be adapted depending on electric device. This is not limited in some embodiments of this application.

The structure of the charge and discharge apparatus is not particularly limited in some embodiments of this application, for example, including a charge and discharge circuit well known in the art. This is not limited in some embodiments of this application. The charge current is not particularly limited in some embodiments of this application. For example, it may be any current between 0.1A and 3A, such as 0.1A, 0.2A, 0.3A, 0.5A, 0.7A, 1A, 1.5A, 2A, 2.5A, or 3A.

Step ii: Perform an intermittent charge operation on the electrochemical apparatus at a detection current, obtain data related to the electrochemical apparatus in the intermittent charge operation, and determine a lithium precipitation SOC of the electrochemical apparatus based on the data related to the electrochemical apparatus.

In some embodiments of this application, the intermittent charge operation may refer to a process of intermittently charging the electrochemical apparatus. The lithium precipitation SOC (State Of Charge, state of charge) may refer to an SOC related to a lithium precipitation state of the electrochemical apparatus.

For example, a lithium precipitation SOC analysis apparatus 502 in the battery management system can perform the intermittent charge operation on the electrochemical apparatus. The SOC analysis apparatus is not particularly limited in some embodiments of this application, as long as the intermittent charge operation can be implemented. The lithium precipitation SOC analysis apparatus 502 may be a controller unit (Microcontroller Unit, MCU) in the battery management system (Battery Management System, BMS). In an example, after the charge and discharge apparatus 501 performs a first number of first charge-discharge cycles on the electrochemical apparatus, in response to the first number of first charge-discharge cycles being reached, the lithium precipitation SOC analysis apparatus 502 performs the intermittent charge operation on the electrochemical apparatus at the detection current, performs lithium precipitation detection analysis on the electrochemical apparatus during the intermittent charge operation, obtains the data related to the electrochemical apparatus in the intermittent charge operation, and determines the lithium precipitation SOC of the electrochemical apparatus based on the data related to the electrochemical apparatus. The operations in the foregoing process are for the purpose of description only.

In a possible implementation, the data related to the electrochemical apparatus may refer to data that can reflect the status of the electrochemical apparatus, including but not limited to data such as charge voltage, charge current, internal resistance, and SOC of the electrochemical apparatus.

The charge method in the intermittent charge operation is not particularly limited in some embodiments of this application, as long as the purpose of some embodiments of this application can be achieved. The charge may be constant voltage charge, constant current charge, constant current and constant voltage charge, or staged constant current charge.

Step iii-1: In response to the lithium precipitation SOC of the electrochemical apparatus being higher than a first SOC threshold, perform a second charge-discharge cycle on the electrochemical apparatus at the charge current.

The lithium precipitation SOC can refer to an SOC related to a lithium precipitation state of the electrochemical apparatus. The first SOC threshold may be a preset threshold, and the first SOC threshold may be stored in advance in a storage medium connected to the electrochemical apparatus. For the electrochemical apparatus, when the lithium precipitation SOC of the electrochemical apparatus is low to a certain extent, there is a risk that the battery cell inside the electrochemical apparatus catches fire if still used. In order to determine in advance that the electrochemical apparatus is subjected to a risk of catching fire if still used, the first SOC threshold may be higher than the lithium precipitation SOC at which the electrochemical apparatus has a risk of catching fire. For example, if the lithium precipitation SOC at which the electrochemical apparatus has a risk of catching fire is 10%, the first SOC threshold may be 15%.

After the lithium precipitation SOC of the electrochemical apparatus is determined, when the lithium precipitation SOC of the electrochemical apparatus is higher than the first SOC threshold, it indicates that the electrochemical apparatus has not subjected to lithium precipitation yet and therefore can continue operating. Based on this, in some embodiments of this application, the second charge-discharge cycle may be performed on the electrochemical apparatus at the charge current to make the electrochemical apparatus maintain operating. This alleviates the "false killing" problem that the electrochemical apparatus is discarded before its service life is reached.

In an example, the lithium precipitation SOC analysis apparatus 502 performs the intermittent charge operation on the electrochemical apparatus, performs lithium precipitation detection analysis on the electrochemical apparatus during the intermittent charge operation, and when the lithium precipitation SOC of the electrochemical apparatus is higher than the first SOC threshold, sends a first signal to the charge and discharge apparatus 501. After receiving the first signal, the charge and discharge apparatus 501 performs the second charge-discharge cycle on the electrochemical apparatus at the charge current.

The number of second charge-discharge cycles may be smaller than or equal to the number of first charge-discharge cycles. This is because as the cycling of the electrochemical apparatus continues, a lithium precipitation window thereof gradually narrows, that is, lithium precipitation is more likely to occur. Therefore, the number of second charge-discharge cycles is set to be smaller than the number of first charge-discharge cycles, so that after the number of second charge-discharge cycles is reached, whether lithium precipitation detection analysis is required on the electrochemical apparatus can be determined again.

In some embodiments of this application, for example, the number of first charge-discharge cycles may be 1 to 500, and the number of second charge-discharge cycles may be 1 to 100. The operations of the process shown above are for illustrative purposes only. In addition, the apparatuses and modules in the battery management system examples in some embodiments of this application are only for illustrative purposes rather than restrictive purposes.

Step iii-2: In response to the lithium precipitation SOC of the electrochemical apparatus being lower than or equal to the first SOC threshold, control the electrochemical apparatus to perform a risk control operation.

The risk control operation includes an operation that can reduce the safety risk of the battery.

For example, the risk can be reduced by adjusting the charge current, charge voltage, charge mode, and the like of the electrochemical apparatus. The charge mode includes a combination of one or more constant current charge, constant voltage charge, direct current charge, and alternating current charge. Example charge modes include constant current-constant voltage charge and multi-stage constant current-constant voltage charge. The constant current-constant voltage charge includes at least one constant current-constant voltage charge stage. Charge and discharge parameters of multiple constant current-constant voltage charge stages can be set to the same or different, and are not limited herein. The multi-stage constant current-constant voltage charge includes multiple consecutive constant current charge stages and one constant voltage charge stage. Charge and discharge parameters of the multiple constant current charge stages can be set to the same or different, and are not limited herein.

For another example, the possible risk may be avoided by stopping using the electrochemical apparatus. In some embodiments, the risk control operation includes at least one of the following: reducing a charge voltage of the electrochemical apparatus, reducing a charge current of the electrochemical apparatus, performing staged charge on the electrochemical apparatus, or generating risk reminder information.

For example, the lithium precipitation SOC analysis apparatus 502 performs the intermittent charge operation on the electrochemical apparatus, performs lithium precipitation detection analysis during the intermittent charge operation, and when the lithium precipitation SOC is lower than or equal to the first SOC threshold, sends a second signal to a protection apparatus 503. After receiving the second signal, the protection apparatus 503 can perform a risk control operation.

In some embodiments, the risk control operation includes at least one of the following: reducing a charge voltage of the electrochemical apparatus, reducing a charge current of the electrochemical apparatus, performing staged charge on the electrochemical apparatus, or generating risk reminder information.

The staged charge includes multiple charge stages. At least two of the multiple charge stages have different charge parameters or charge modes. For example, in different charge stages of the electrochemical apparatus, currents or voltages of different magnitudes or different charge modes may be used to charge the electrochemical apparatus.

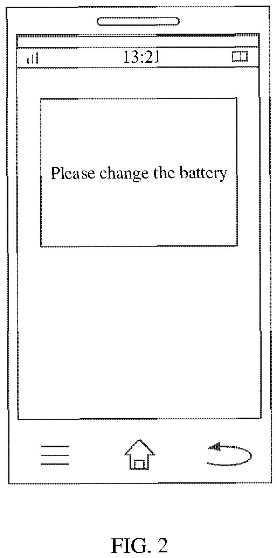

The generating risk reminder information may include generating reminders to replace the electrochemical apparatus, perform maintenance on the electrochemical apparatus, replace the charge method of the electrochemical apparatus, and the like. For example, FIG. 2 is a schematic diagram of risk reminder information. In FIG. 2, a user is reminded to replace the electrochemical apparatus through the text "Please change the battery". Certainly, in addition to texts, the risk reminder information can also take other forms such as videos, pictures, or audios. This is not specifically limited in some embodiments of this application. Optionally, the risk reminder information may be provided in any interactive manner such as text message, application message, email, or phone call. For example, the risk reminder information in FIG. 2 may be displayed through an application program.

Controlling the electrochemical apparatus to perform the risk control operation can reduce the risk of lithium precipitation caused by continual use of the electrochemical apparatus, thereby improving the use safety of the electrochemical apparatus. The operations of the process shown above are for illustrative purposes only. In addition, the apparatuses and modules in the electronic device examples in some embodiments of this application are only for illustrative purposes rather than restrictive purposes.

According to the electrochemical apparatus management method, the system, the electrochemical apparatus, and the electronic device provided in some embodiments of this application, the intermittent charge operation is performed on the electrochemical apparatus, the data related to the electrochemical apparatus is obtained in the intermittent charge operation, the lithium precipitation SOC of the electrochemical apparatus is determined based on the related data, and then based on the magnitude relationship between the lithium precipitation SOC and the first SOC threshold, the electrochemical apparatus is controlled to stop operating or the electrochemical apparatus is controlled to perform a risk control operation. This reduces the safety hazards caused when the electrochemical apparatus is still in use after lithium precipitation, thereby improving the safety of the electrochemical apparatus during use. Certainly, when any one of the products or methods of some embodiments of this application is implemented, all advantages described above are not necessarily demonstrated simultaneously.

In an implementation of this application, step ii and step iii-1 or step iii-2 is repeated after step iii-1. When the lithium precipitation SOC of the electrochemical apparatus is lower than or equal to the first SOC threshold, lithium precipitation detection analysis may be performed on the electrochemical apparatus through the intermittent charge operation again, so that the risk of lithium precipitation is reduced throughout the full life cycle of the electrochemical apparatus.

In an implementation of this application, after step iii-1 or step iii-2, the method further includes:
performing a third charge-discharge cycle on the electrochemical apparatus;
in response to completing the third charge-discharge cycle, performing the step of performing an intermittent charge operation on the electrochemical apparatus at a detection current, obtaining data related to the electrochemical apparatus in the intermittent charge operation, and determining a lithium precipitation SOC of the electrochemical apparatus based on the data related to the electrochemical apparatus; and
in response to the lithium precipitation SOC of the electrochemical apparatus being lower than or equal to a second SOC threshold, controlling the electrochemical apparatus to stop operating, where the second SOC threshold is lower than the first SOC threshold.

When the lithium precipitation SOC of the electrochemical apparatus is higher than the first SOC threshold, it indicates that the electrochemical apparatus has no risk of lithium precipitation for the time being, or when the lithium precipitation SOC of the electrochemical apparatus is lower than or equal to the first SOC threshold, the risk in continued use of the electrochemical apparatus has been reduced by performing the risk control operation. However, after step iii-1 or step iii-2, with the continued use of the electrochemical apparatus, the lithium precipitation SOC of the electrochemical apparatus further decreases, and when the lithium precipitation SOC of the electrochemical apparatus drops to a certain level, the battery cell in the electrochemical apparatus has a risk of catching fire if still used. Therefore, in order to prevent the electrochemical apparatus from catching fire and further reduce the risk of lithium precipitation, the third charge-discharge cycle may be performed on the electrochemical apparatus, after the third charge-discharge cycle, lithium precipitation detection analysis is performed on the electrochemical apparatus, and in response to the lithium precipitation SOC of the electrochemical apparatus being lower than or equal to the second SOC threshold, the electrochemical apparatus is controlled to stop operating.

The number of third charge-discharge cycles may be smaller than or equal to the number of second charge-discharge cycles. This is because as the cycling of the electrochemical apparatus continues, a lithium precipitation window thereof gradually narrows, that is, lithium precipitation is more likely to occur. Therefore, the number of third charge-discharge cycles is set to be smaller than the number of the charge-discharge cycles, so that after the number of second charge-discharge cycles, whether lithium precipitation detection analysis is required on the electrochemical apparatus can be determined again. In some embodiments of this application, for example, the number of third charge-discharge cycles may be 1 to 50, for example, 10.

It can be understood that if the third charge-discharge cycle is performed after step iii-1, a charge current in the third charge-discharge cycle is the same as a charge current in the second charge-discharge cycle. Further, in some embodiments, other charge parameters (for example, charge voltage) and a charge mode in the third charge-discharge cycle are also the same as those in the second charge-discharge cycle. If the third charge-discharge cycle is performed after step iii-2, the third charge-discharge cycle is performed by using the charge current, charge voltage, and charge mode adjusted in step iii-2. For example, if the charge current is reduced in step iii-2, the charge current in the third charge-discharge cycle is lower than the charge current in the second charge-discharge cycle.

The second SOC threshold may be a lithium precipitation SOC at which the battery cell inside the electrochemical apparatus may catch fire if it is still used. The electrochemical apparatus is a nickel-cobalt-manganese system electrochemical apparatus, and the second SOC threshold is higher than or equal to 10% and lower than or equal to 30%; or the electrochemical apparatus is a lithium manganate system electrochemical apparatus, and the second SOC threshold is higher than or equal to 20% and lower than or equal to 40%. In some embodiments of this application, the second SOC threshold is lower than the first SOC threshold. Optionally, a difference between the first SOC threshold and the second SOC threshold may be higher than a preset difference, such as 3%, that is, first SOC threshold - second SOC threshold ≥ 3%.

In an example, the lithium precipitation SOC analysis apparatus 502 performs the intermittent charge operation on the electrochemical apparatus, performs lithium precipitation detection analysis during the intermittent charge operation, and sends a third signal to the protection apparatus 503 when the lithium precipitation SOC is lower than or equal to the second SOC threshold. After receiving the third signal, the protection apparatus 503 disconnects the electrical connection to the electrochemical apparatus so as to stop the electrochemical apparatus from operation. The operations of the process shown above are for illustrative purposes only. In addition, the apparatuses and modules in the battery management system examples in some embodiments of this application are only for illustrative purposes rather than restrictive purposes.

In some embodiments of this application, when the lithium precipitation SOC of the electrochemical apparatus is lower than or equal to the second SOC threshold, the electrochemical apparatus may be controlled to stop operating. Generally, when the lithium precipitation SOC of the electrochemical apparatus is lower than or equal to the second SOC threshold, it indicates that the lithium precipitation SOC of the electrochemical apparatus has become very small, and the electrochemical apparatus is severely aged and therefore is not suitable for use any more. In this case, the electrochemical apparatus can be disconnected to stop the electrochemical apparatus from working, reduce the risk of lithium precipitation in the electrochemical apparatus caused by continued operation, and improve the use safety of the electrochemical apparatus.

The intermittent charge operation may refer to a process of intermittently charging the electrochemical apparatus. In an implementation of this application, the intermittent charge operation includes multiple charge periods and multiple interruption periods. The lithium precipitation SOC of the electrochemical apparatus is determined in the following manner.

Step A: In the intermittent charge operation, for each of the multiple interruption periods, obtain an SOC of the electrochemical apparatus and an internal resistance of the electrochemical apparatus that are corresponding to the interruption period.

Step B: Obtain a first curve based on the obtained multiple SOCs of the electrochemical apparatus and the multiple internal resistances of the electrochemical apparatus corresponding to the multiple SOCs.

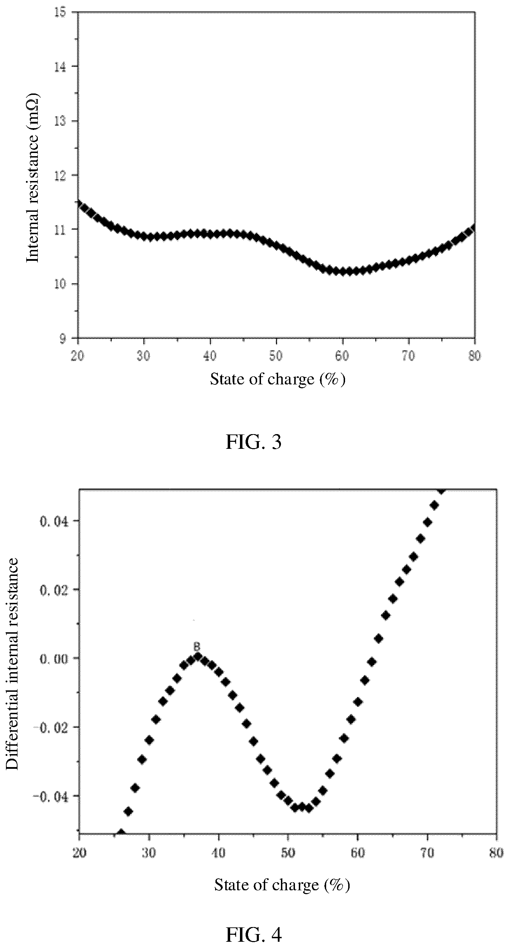

In some embodiments of this application, after obtaining the SOCs and internal resistances of the electrochemical apparatus in the multiple interruption periods, multiple data pairs composed of the SOCs and internal resistances may be obtained. Referring to FIG. 3, SOCs of the electrochemical apparatus may be used as horizontal coordinates, and internal resistances of the electrochemical apparatus may be used as vertical coordinates. Points represented by these data pairs are filled in the coordinate system, and fitting is performed to obtain the first curve. The first curve is a corresponding mapping curve between the SOCs and internal resistances of the electrochemical apparatus.

It can be understood that more SOCs and internal resistances of the electrochemical apparatus collected mean that more data pairs may be obtained, and a more detailed first curve may be obtained. The process of using data for curve fitting is well known to those skilled in the art, and this is not specifically limited in some embodiments of this application.

Step C: Determine the lithium precipitation SOC of the electrochemical apparatus based on the first curve.

The first curve is a curve showing mappings of the SOCs and internal resistances of the electrochemical apparatus, and the lithium precipitation SOC of the electrochemical apparatus may be determined based on the first curve.

The lithium precipitation SOC may not be measured in real time, but is obtained by using a charge voltage obtained during the intermittent charge operation and the correspondence table of charge voltage and SOC. The correspondence table may be stored in advance in the battery management system, electrochemical apparatus, or storage medium of the electronic device.

In an implementation, the process of determining the lithium precipitation SOC of the electrochemical apparatus based on the first curve may be method 1. Method 1 includes the following steps.
a: Perform first-order differential on the first curve to obtain a second curve.
   As shown in FIG. 4, after the first curve is subjected to first-order differential, the second curve is obtained. The second curve represents the change rate of the internal resistance of the electrochemical apparatus with respect to the SOC.
b: Determine, as the lithium precipitation SOC, an SOC corresponding to a point at which the second curve first has a negative slope.

The second curve represents the change rate of internal resistance with respect to SOC. When the change rate does not show an abnormal drop in a flat region of the curve, it indicates that no active lithium is precipitated. When the change rate shows an abnormal drop in the flat region of the curve, since the active lithium is precipitated on the surface of the negative electrode and comes into contact with the negative electrode, which is equivalent to a graphite part of the negative electrode being connected in parallel with a lithium metal device, reducing the impedance of the entire negative electrode. As a result, the impedance of the electrochemical apparatus abnormally decreases when active lithium is precipitated, and correspondingly, the abnormal decrease occurs in the in flat region of the second curve. Referring to FIG. 4, point B is the first point in the second curve at which the slope is negative. That is, at point B, an abnormal decrease occurs in the flat region of the second curve for the first time, indicating that the electrochemical apparatus has a tendency to precipitate lithium at point B or has already precipitated lithium. The SOC corresponding to point B can be determined as the lithium precipitation SOC, so that based on a magnitude relationship between the lithium precipitation SOC and the SOC threshold, the electrochemical apparatus can be protected in a timely manner to improve the use safety of the electrochemical apparatus. The steps a to c are only used to describe the order of the steps, but not to limit the order of the steps.

In an implementation, the process of determining the lithium precipitation SOC of the electrochemical apparatus based on the first curve may be method 2. Method 2 includes the following steps.

a': Perform a first-order differential on the first curve to obtain a second curve.

This step is the same as step a of the method 1 and will not be described in detail herein again.

b': Perform a second-order differential on the second curve to obtain a third curve.

The second-order differential may further be performed on the second curve to obtain the third curve. It can be understood that the third curve is a second-order differential curve of the second curve.

c': Determine, as the lithium precipitation SOC, an SOC corresponding to a point at which the third curve first has a vertical coordinate less than zero.

If a vertical coordinate of the third curve is less than zero, the SOC corresponding to the point at which the third curve first has a vertical coordinate less than zero is determined as the lithium precipitation SOC.

The intermittent charge operation in some embodiments of this application includes multiple charge cycles, and each charge cycle includes one charge period and one interruption period. For example, a first charge period and a first interruption period form the first charge cycle, a second charge period and a second interruption period form the second charge cycle, a third charge period and a third interruption period form the third charge cycle, and so on. It can be understood that a charge cycle is a continuous period of time.

For example, the electrochemical apparatus is charged during the first charge period, and then the charge is stopped. After the first interruption period elapses, the electrochemical apparatus is continued to be charged in the second charge period. This is repeated until the SOC of the electrochemical apparatus reaches a first critical value. It can be understood that as intermittent charge continues, the SOC of the electrochemical apparatus increases. In some embodiments of this application, the intermittent charge may be stopped when the SOC of the electrochemical apparatus reaches the first critical value, and the intermittent charge operation is completed. The first critical value is not particularly limited in some embodiments of this application, as long as the purpose of this application can be achieved. For example, the first critical value may be 60%, 70%, 80%, 90%, or 100%.

During the intermittent charge operation, unit amplitudes of SOCs corresponding to different charge cycles may be different. For example, the electrochemical apparatus is charged in the first charge period, and after the SOC of the electrochemical apparatus increases by 1%, the charge is stopped. After an interval of 5 seconds, the electrochemical apparatus is charged during the second charge period, and after the SOC of the electrochemical apparatus increases by 5%, the charge is stopped. After an interval of 5 seconds, the electrochemical apparatus is charged during the third charge period, and after the SOC of the electrochemical apparatus increases by 3%, the charge is stopped. This is repeated until the SOC of the electrochemical apparatus reaches the first threshold.

In an implementation, the intermittent charge operation may be specifically as follows: for any one of multiple charge cycles, the electrochemical apparatus is charged at the first moment until the SOC of the electrochemical apparatus increases by the unit amplitude. Before the third moment, the moment when the charge is stopped is the second moment, and a time interval between the third moment and the second moment is the duration of the interruption period. During the interruption period, the electrochemical apparatus may be in a state of neither being charged nor being discharged, that is, a static state.

For example, at a moment T1, the electrochemical apparatus is charged until the SOC of the electrochemical apparatus increases by the unit amplitude. The moment when the charge is stopped is a moment T2. Starting from the moment T2, the electrochemical apparatus is left standing, and a standing end moment is a moment T3.

In some embodiments of this application, the data related to the electrochemical apparatus can be obtained in the intermittent charge operation by performing the intermittent charge operation on the electrochemical apparatus, and the lithium precipitation SOC of the electrochemical apparatus is determined based on the data, so as to execute the step of charging the electrochemical apparatus at an original charge current or reduced current. This helps to reduce the risk of lithium precipitation of the electrochemical apparatus and prolong the service life of the electrochemical apparatus.

The electrochemical apparatus according to some embodiments of this application includes at least one of lithium iron phosphate system electrochemical apparatus, lithium nickel manganese cobalt system electrochemical apparatus, or lithium cobalt system electrochemical apparatus. Generally, in the intermittent charge operation, electrochemical apparatuses of different systems correspond to different unit amplitudes and different interruption period durations. Hence, there are the following cases.

In an implementation, in a case that the electrochemical apparatus is a lithium iron phosphate system electrochemical apparatus, the unit amplitude ranges from 0.5% to 10%, and a duration of the interruption period cycle ranges from 1 second to 15 seconds.

In an implementation, in a case that the electrochemical apparatus is a lithium nickel manganese cobalt system electrochemical apparatus, the unit amplitude ranges from 0.5% to 10%, and a duration of the interruption period ranges from 1 second to 30 seconds.

In an implementation, in a case that the electrochemical apparatus is a lithium cobalt system electrochemical apparatus, the unit amplitude ranges from 0.5% to 10%, and a duration of the interruption period ranges from 1 second to 30 seconds.

In some embodiments of this application, with different unit amplitudes and different interruption period durations set for electrochemical apparatuses of different systems, a more targeted intermittent charge operation can be performed on the electrochemical apparatuses of different systems, so that a more accurate lithium precipitation SOC can be obtained for electrochemical apparatuses of different systems.

Generally, in the intermittent charge operation, electrochemical apparatuses of a same system correspond to different unit amplitudes and different interruption period durations under different temperatures. Hence, there are the following cases.

In an implementation, in a case that the electrochemical apparatus is a lithium iron phosphate system electrochemical apparatus and the electrochemical apparatus is at an ambient temperature of -10°C to 10°C, the unit amplitude ranges from 0.5% to 10%, and a duration of the interruption period ranges from 5 seconds to 15 seconds. In an implementation, in a case that the electrochemical apparatus is a lithium iron phosphate system electrochemical apparatus and the electrochemical apparatus is at an ambient temperature of 10°C to 45°C, the unit amplitude ranges from 0.5% to 10%, and a duration of the interruption period ranges from 1 second to 10 seconds.

In some embodiments of this application, the positive electrode of the lithium iron phosphate system electrochemical apparatus may further include other positive electrode active materials, but lithium iron phosphate is the main material. For example, the lithium iron phosphate accounts for any one of 51%, 60%, 70%, 80%, 90%, and 98% of the total mass of the positive electrode active material.

In an implementation, in a case that the electrochemical apparatus is a lithium nickel manganese cobalt system electrochemical apparatus and the electrochemical apparatus is at an ambient temperature of -10°C to 10°C, the unit amplitude ranges from 0.5% to 10%, and a duration of the interruption period ranges from 10 seconds to 30 seconds. In an implementation, in a case that the electrochemical apparatus is a lithium nickel manganese cobalt system electrochemical apparatus and the electrochemical apparatus is at an ambient temperature of 10°C to 45°C, the unit amplitude ranges from 0.5% to 10%, and a duration of the interruption period ranges from 1 second to 10 seconds.

In some embodiments of this application, the positive electrode of the lithium nickel manganese cobalt system electrochemical apparatus may further include other positive electrode active materials, but lithium nickel manganese cobalt is the main material. For example, the lithium nickel manganese cobalt accounts for any one of 51%, 60%, 70%, 80%, 90%, and 98% of the total mass of the positive electrode active material.

In an implementation, in a case that the electrochemical apparatus is a lithium cobalt system electrochemical apparatus and the electrochemical apparatus is at an ambient temperature of -10°C to 10°C, the unit amplitude ranges from 0.5% to 10%, and a duration of the interruption period ranges from 15 seconds to 30 seconds. In an implementation, in a case that the electrochemical apparatus is a lithium cobalt system electrochemical apparatus and the electrochemical apparatus is at an ambient temperature of 10°C to 45°C, the unit amplitude ranges from 0.5% to 10%, and a duration of the interruption period ranges from 1 second to 10 seconds.

In some embodiments of this application, the positive electrode of the lithium cobalt system electrochemical apparatus may further include other positive electrode active materials, but lithium cobalt is the main material. For example, the lithium cobalt accounts for any one of 51%, 60%, 70%, 80%, 90%, and 98% of the total mass of the positive electrode active material.

In some embodiments of this application, with different unit amplitudes and different interruption period durations set for electrochemical apparatuses of a same system under different temperatures, a more targeted intermittent charge operation can be performed on the electrochemical apparatuses in different temperature environments, so that a more accurate lithium precipitation SOC can be obtained for electrochemical apparatuses of different systems.

The SOC threshold can refer to an SOC corresponding to lithium precipitation of the electrochemical apparatus, and is usually related to the system of the electrochemical apparatus. The SOC threshold in some embodiments of this application may be set depending on actual needs. The SOC threshold may vary with characteristics of electrochemical apparatuses of different systems. For example, when the electrochemical apparatus is a lithium iron phosphate system electrochemical apparatus, the SOC threshold ranges from 30% to 70%, such as 30%, 40%, 50%, 60%, or 70%; when the electrochemical apparatus is a lithium nickel manganese cobalt system electrochemical apparatus, the SOC threshold ranges from 20% to 50%, such as 20%, 30%, 40%, or 50%; and when the electrochemical apparatus is a lithium cobalt system electrochemical apparatus, the SOC threshold ranges from 20% to 50%, such as 20%, 30%, 40%, or 50%.

With different SOC thresholds set for electrochemical apparatuses of different systems, the management strategies of electrochemical apparatuses of different systems can be optimized in a more targeted manner, and the safe service life of electrochemical apparatuses of different systems can be prolonged.

In an implementation, the steps of generating the first curve includes the following steps.

Step a: Obtain a first voltage, first current, and first SOC of the electrochemical apparatus at the second moment, and a second voltage and second current of the electrochemical apparatus at the third moment.

The second moment is a moment when the charge is stopped. The voltage, current, and SOC, namely, the first voltage, first current, and first SOC, of the electrochemical apparatus at the second moment may be obtained, which are denoted as V1, I1, and SOC1, respectively. Similarly, a voltage and current, namely, the second voltage and second current, of the electrochemical apparatus at the third moment may be obtained, which are denoted as V2 and I2, respectively.

Step b: Calculate a voltage change value and current change value of the electrochemical apparatus during the interruption period.

The duration of the interruption period is the time interval between the third moment and the second moment. The voltage change value of the electrochemical apparatus during the interruption period is ΔV, with ΔV=V2 - V1. The current change value of the electrochemical apparatus during the interruption period is ΔI, with ΔI=I2 - I1.

Step c: Calculate a first internal resistance of the electrochemical apparatus during the interruption period based on the voltage change value and current change value, and use the first internal resistance and the first SOC as one of data pairs of the first curve, where the data pair is a correspondence between internal resistance and SOC.

The first internal resistance of the electrochemical apparatus during the interruption period is R1, and R1=ΔV/ΔI. R1 and SOC1 are used as one of the data pairs of the first curve.

Multiple data pairs can be obtained by using the same method as described above.

Step d: Generate the first curve based on the multiple data pairs obtained through calculation.

SOCs of the electrochemical apparatus are used as horizontal coordinates, and internal resistances of the electrochemical apparatus are used as vertical coordinates. Points represented by these data pairs are filled in the coordinate system, and fitting is performed to obtain the first curve. In some embodiments of this application, after the first curve is obtained, the lithium precipitation SOC of the electrochemical apparatus can be determined through the first curve. Thus, the step of charging the electrochemical apparatus at an original charge current or reduced current can be executed based on the magnitude relationship between the lithium precipitation SOC and the SOC threshold. This helps to reduce the risk of lithium precipitation of the electrochemical apparatus and prolong the service life of the electrochemical apparatus.

According to the electrochemical apparatus management method provided in some embodiments of this application, the lithium precipitation SOC of the electrochemical apparatus is determined based on the data related to the electrochemical apparatus obtained during the intermittent charge operation. In response to the lithium precipitation SOC of the electrochemical apparatus being lower than or equal to the SOC threshold, the electrochemical apparatus is charged with a smaller charge current, namely, a target charge current, so that the risk control operations can be performed to reduce the risk of lithium precipitation and improve the safety of the electrochemical apparatus.

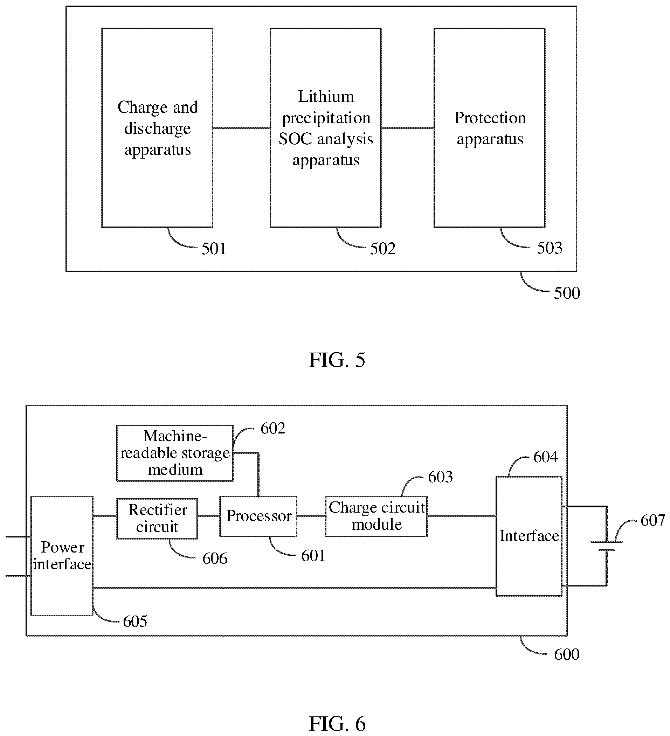

An embodiment of this application further provides a system 500. As shown in FIG. 5, the electronic device 500 includes: a charge and discharge apparatus 501, a lithium precipitation SOC analysis apparatus 502, and a protection apparatus 503.

The charge and discharge apparatus 501 is configured to perform a first charge-discharge cycle on an electrochemical apparatus at a charge current.

The lithium precipitation SOC analysis apparatus 502 is configured to perform an intermittent charge operation on the electrochemical apparatus at a detection current, obtain data related to the electrochemical apparatus in the intermittent charge operation, and determine a lithium precipitation SOC of the electrochemical apparatus based on the data related to the electrochemical apparatus.

The protection apparatus 503 is configured to: in response to the lithium precipitation SOC of the electrochemical apparatus being higher than a first SOC threshold, perform a second charge-discharge cycle on the electrochemical apparatus at the charge current, or in response to the lithium precipitation SOC of the electrochemical apparatus being lower than or equal to the first SOC threshold, control the electrochemical apparatus to perform a risk control operation.

The charge and discharge apparatus 501, the lithium precipitation SOC analysis apparatus 502, and the protection apparatus 503 are not limited to a particular structure in some embodiments of this application, as long as the corresponding functions can be implemented.

In an implementation, after the protection apparatus 503 performs an operation, the operations by the lithium precipitation SOC analysis apparatus 502 and the protection apparatus 503 are repeatedly performed.

In an implementation, the charge and discharge apparatus 501 is further configured to perform a third charge-discharge cycle on the electrochemical apparatus after the protection apparatus 503 performs the second charge-discharge cycle on the electrochemical apparatus at the charge current or control the electrochemical apparatus to perform the risk control operation.

The lithium precipitation SOC analysis apparatus 502 is further configured to: in response to completing the third charge-discharge cycle, perform the step of performing an intermittent charge operation on the electrochemical apparatus at a detection current, obtain data related to the electrochemical apparatus in the intermittent charge operation, and determine a lithium precipitation SOC of the electrochemical apparatus based on the data related to the electrochemical apparatus.

The protection apparatus 503 is further configured to: in response to the lithium precipitation SOC of the electrochemical apparatus being lower than or equal to a second SOC threshold, control the electrochemical apparatus to stop operating, where the second SOC threshold is lower than the first SOC threshold.

In an implementation, the electrochemical apparatus is a nickel-cobalt-manganese system electrochemical apparatus, and the second SOC threshold is higher than or equal to 10% and lower than or equal to 30%; or the electrochemical apparatus is a lithium manganate system electrochemical apparatus, and the second SOC threshold is higher than or equal to 20% and lower than or equal to 40%.

In an implementation, at least one of the following conditions is satisfied:
the number of first charge-discharge cycles is not smaller than the number of second charge-discharge cycles; or
the number of second charge-discharge cycles is not smaller than the number of third charge-discharge cycles.

In an implementation, the number of first charge-discharge cycles is 1 to 500, the number of second charge-discharge cycles is 1 to 100, and the number of third charge-discharge cycles is 1 to 50.

In an implementation, the data related to the electrochemical apparatus includes an SOC of the electrochemical apparatus and an internal resistance of the electrochemical apparatus, and the intermittent charge operation includes multiple charge periods and multiple interruption periods.

The lithium precipitation SOC analysis apparatus 502 is specifically configured to: in the intermittent charge operation, for each of the multiple interruption periods, obtain an SOC of the electrochemical apparatus and an internal resistance of the electrochemical apparatus that are corresponding to the interruption period, and obtain a first curve based on the obtained multiple SOCs of the electrochemical apparatus and the multiple internal resistances of the electrochemical apparatus corresponding to the multiple SOCs, where the first curve is a corresponding mapping curve between the SOCs and internal resistances of the electrochemical apparatus; and determine the lithium precipitation SOC of the electrochemical apparatus based on the first curve.

In an implementation, the lithium precipitation SOC analysis apparatus 502 is specifically configured to: perform a first-order differential on the first curve to obtain a second curve, and determine, as the lithium precipitation SOC, an SOC corresponding to a point at which the second curve first has a negative slope; or perform a first-order differential on the first curve to obtain a second curve, perform a second-order differential on the second curve to obtain a third curve, and determine, as the lithium precipitation SOC, an SOC corresponding to a point at which the third curve first has a vertical coordinate less than zero.

In an implementation, the intermittent charge operation includes multiple charge periods, each charge cycle includes a charge period and an interruption period, and in each charge cycle, SOC of the electrochemical apparatus increases by a unit amplitude.

In an implementation, the electrochemical apparatus includes at least one of lithium iron phosphate system electrochemical apparatus, lithium nickel manganese cobalt system electrochemical apparatus, or lithium cobalt system electrochemical apparatus, where in a case that the electrochemical apparatus is a lithium iron phosphate system electrochemical apparatus, the unit amplitude ranges from 0.5% to 10%, and a duration of the interruption period ranges from 1 second to 15 seconds; in a case that the electrochemical apparatus is a lithium nickel manganese cobalt system electrochemical apparatus, the unit amplitude ranges from 0.5% to 10%, and a duration of the interruption period ranges from 1 second to 30 seconds; or in a case that the electrochemical apparatus is a lithium cobalt system electrochemical apparatus, the unit amplitude ranges from 0.5% to 10%, and a duration of the interruption period ranges from 1 second to 30 seconds.

In an implementation, the lithium precipitation SOC analysis apparatus 502 is specifically configured to satisfy any one of conditions (a) to (f):
(a) in a case that the electrochemical apparatus is a lithium iron phosphate system electrochemical apparatus and the electrochemical apparatus is at an ambient temperature of -10°C to 10°C, the unit amplitude ranges from 0.5% to 10%, and a duration of the interruption period ranges from 5 seconds to 15 seconds;
(b) in a case that the electrochemical apparatus is a lithium iron phosphate system electrochemical apparatus and the electrochemical apparatus is at an ambient temperature of 10°C to 45°C, the unit amplitude ranges from 0.5% to 10%, and a duration of the interruption period ranges from 1 seconds to 10 seconds;
(c) in a case that the electrochemical apparatus is a lithium nickel manganese cobalt system electrochemical apparatus and the electrochemical apparatus is at an ambient temperature of -10°C to 10°C, the unit amplitude ranges from 0.5% to 10%, and a duration of the interruption period ranges from 10 seconds to 30 seconds;
(d) in a case that the electrochemical apparatus is a lithium nickel manganese cobalt system electrochemical apparatus and the electrochemical apparatus is at an ambient temperature of 10°C to 45°C, the unit amplitude ranges from 0.5% to 10%, and a duration of the interruption period ranges from 1 seconds to 10 seconds;
(e) in a case that the electrochemical apparatus is a lithium cobalt system electrochemical apparatus and the electrochemical apparatus is at an ambient temperature of -10°C to 10°C, the unit amplitude ranges from 0.5% to 10%, and a duration of the interruption period ranges from 15 seconds to 30 seconds; or
(f) in a case that the electrochemical apparatus is a lithium cobalt system electrochemical apparatus and the electrochemical apparatus is at an ambient temperature of 10°C to 45°C, the unit amplitude ranges from 0.5% to 10%, and a duration of the interruption period ranges from 1 seconds to 10 seconds.

In some embodiments, the risk control operation includes at least one of the following: reducing a charge voltage of the electrochemical apparatus, reducing a charge current of the electrochemical apparatus, performing staged charge on the electrochemical apparatus, or generating risk reminder information.

An embodiment of this application provides a system. The intermittent charge operation may be performed on the electrochemical apparatus, the data related to the electrochemical apparatus is obtained in the intermittent charge operation, the lithium precipitation SOC of the electrochemical apparatus is determined based on the related data, and then based on the magnitude relationship between the lithium precipitation SOC and the first SOC threshold, the electrochemical apparatus is controlled to stop operating or the electrochemical apparatus is controlled to perform a risk control operation. This reduces the safety hazards caused when the electrochemical apparatus is still in use after lithium precipitation, thereby improving the safety of the electrochemical apparatus during use. Certainly, when any one of the products or methods of some embodiments of this application is implemented, all advantages described above are not necessarily demonstrated simultaneously.

An embodiment of this application further provides a system. As shown in FIG. 6, the system 600 includes a processor 601 and a machine-readable storage medium 602. The system 600 may further include a charge circuit module 603, an interface 604, a power interface 605, and a rectifier circuit 606. The charge circuit module 603 is configured to receive an instruction issued by the processor 601 to perform an intermittent charge operation on a lithium-ion battery 607. The charge circuit module 603 may be further configured to receive an instruction issued by the processor 601 to reduce a voltage/current of the lithium-ion battery 607, or disconnect the electrical connection to the lithium-ion battery 607 so that the lithium-ion battery 607 stops operating. The charge circuit module 603 may further obtain an SOH (State Of Health, state of health) parameter, a total operation duration, and other parameters of the lithium-ion battery 607, and send these parameters to the processor 601. The interface 604 is configured to electrically connect to the lithium-ion battery 607. The power interface 605 is configured to connect to an external power supply. The rectifier circuit 606 is configured to rectify an input current. The machine-readable storage medium 602 stores a machine-executable instruction that can be executed by the processor, and when the processor 601 executes the machine-executable instruction, the steps of the method described in any one of the foregoing embodiments are implemented.

An embodiment of this application further provides an electrochemical apparatus including the system 600 described in the foregoing embodiments. The electrochemical apparatus may be a battery. The battery is, for example, a secondary battery (for example, a lithium-ion secondary battery, a sodium-ion battery, or a magnesium-ion battery), a primary battery (for example, a lithium primary battery), but is not limited thereto. For example, the electrochemical apparatus includes a lithium-ion battery.

An embodiment of this application further provides an electronic device including the electrochemical apparatus described in the foregoing embodiments. The electrochemical apparatus is connected to an electronic device and supplies power to the electronic device. For example, the electronic device includes a mobile phone or a tablet computer.

The machine-readable storage medium may include a random access memory (Random Access Memory, RAM for short), or may include a non-volatile memory (non-volatile memory), such as at least one disk storage. Optionally, the memory may alternatively be at least one storage apparatus located away from the processor.

The processor may be a general-purpose processor including a central processing unit (Central Processing Unit, CPU for short), a network processor (Network Processor, NP for short), or the like; or may be a digital signal processor (Digital Signal Processing, DSP for short), an application specific integrated circuit (Application Specific Integrated Circuit, ASIC for short), a field-programmable gate array (Field-Programmable Gate Array, FPGA for short) or another programmable logic device, a discrete gate or transistor logic device, or a discrete hardware assembly.

The system/electrochemical apparatus/electronic device embodiment is essentially similar to the method embodiment, and therefore is described briefly. For related information, refer to the descriptions of the related parts in the method embodiment.

The foregoing descriptions are merely preferred embodiments of this application, but are not intended to limit this application. Any modification, equivalent replacement, or improvement made without departing from the spirit and principle of this application shall fall within the protection scope of this application.

It should be noted that relational terms such as "first" and "second" are only used to distinguish one entity or operation from another entity or operation, and do not necessarily require or imply that there is any such actual relationship or order between these entities or operations. Terms "include", "comprise", or any other variations thereof are intended to cover non-exclusive inclusions, such that a process, method, article or device including a series of elements not only includes these elements, but also includes other elements which are not expressly listed, or further includes elements which are inherent to such process, method, article or device. In absence of more constraints, an element preceded by "includes a..." does not preclude existence of other identical elements in the process, method, article, or device that includes the element.

The embodiments in this specification are described in a related manner. For a part that is the same or similar between different embodiments, reference may be made between the embodiments. Each embodiment focuses on differences from other embodiments. In particular, the system embodiment is essentially similar to the method embodiment, and therefore is described briefly. For related information, refer to descriptions of the related parts in the method embodiment.

The foregoing descriptions are merely preferred embodiments of this application, but are not intended to limit this application. Any modification, equivalent replacement, or improvement made without departing from the spirit and principle of this application shall fall within the protection scope of this application.

## Claims

1. An electrochemical apparatus management method, wherein the method comprises:
i: performing a first charge-discharge cycle on an electrochemical apparatus at a charge current;
ii: performing an intermittent charge operation on the electrochemical apparatus at a detection current, obtaining data related to the electrochemical apparatus in the intermittent charge operation, and determining a lithium precipitation SOC of the electrochemical apparatus based on the data related to the electrochemical apparatus; and
iii-1: in response to the lithium precipitation SOC of the electrochemical apparatus being higher than a first SOC threshold, performing a second charge-discharge cycle on the electrochemical apparatus at the charge current;
or
iii-2: in response to the lithium precipitation SOC of the electrochemical apparatus being lower than or equal to the first SOC threshold, controlling the electrochemical apparatus to perform a risk control operation.

2. The electrochemical apparatus management method according to claim 1, wherein the electrochemical apparatus management method further comprises:
repeating step ii and step iii-1 or step iii-2 after step iii-1.

3. The electrochemical apparatus management method according to claim 1, wherein after step iii-1 or step iii-2, the method further comprises:
performing a third charge-discharge cycle on the electrochemical apparatus;
in response to completing the third charge-discharge cycle, performing the step of performing an intermittent charge operation on the electrochemical apparatus at a detection current, obtaining data related to the electrochemical apparatus in the intermittent charge operation, and determining a lithium precipitation SOC of the electrochemical apparatus based on the data related to the electrochemical apparatus; and
in response to the lithium precipitation SOC of the electrochemical apparatus being lower than or equal to a second SOC threshold, controlling the electrochemical apparatus to stop operating, wherein the second SOC threshold is lower than the first SOC threshold.

4. The electrochemical apparatus management method according to claim 3, wherein the electrochemical apparatus is a nickel-cobalt-manganese system electrochemical apparatus, and the second SOC threshold is higher than or equal to 10% and lower than or equal to 30%; or
the electrochemical apparatus is a lithium manganate system electrochemical apparatus, and the second SOC threshold is higher than or equal to 20% and lower than or equal to 40%.

5. The electrochemical apparatus management method according to claim 3, satisfying at least one of the following conditions:
the number of first charge-discharge cycles is not smaller than the number of second charge-discharge cycles; or
the number of second charge-discharge cycles is not smaller than the number of third charge-discharge cycles.

6. The electrochemical apparatus management method according to claim 5, wherein the number of first charge-discharge cycles is 1 to 500, the number of second charge-discharge cycles is 1 to 100, and the number of third charge-discharge cycles is 1 to 50.

7. The electrochemical apparatus management method according to claim 1, wherein the data related to the electrochemical apparatus comprises an SOC of the electrochemical apparatus and an internal resistance of the electrochemical apparatus, the intermittent charge operation comprises multiple charge periods and multiple interruption periods, and the step of obtaining data related to the electrochemical apparatus in the intermittent charge operation, and determining a lithium precipitation SOC of the electrochemical apparatus based on the data related to the electrochemical apparatus comprises:
in the intermittent charge operation, for each of the multiple interruption periods, obtaining an SOC of the electrochemical apparatus and an internal resistance of the electrochemical apparatus that are corresponding to the interruption period, and obtaining a first curve based on the obtained multiple SOCs of the electrochemical apparatus and the multiple internal resistances of the electrochemical apparatus corresponding to the multiple SOCs, wherein the first curve is a corresponding mapping curve between the SOCs and internal resistances of the electrochemical apparatus; and
determining the lithium precipitation SOC of the electrochemical apparatus based on the first curve.

8. The electrochemical apparatus management method according to claim 7, wherein the step of determining the lithium precipitation SOC of the electrochemical apparatus based on the first curve comprises at least one of method 1 or method 2, wherein:
method 1 comprises:
performing a first-order differential on the first curve to obtain a second curve, and
determining, as the lithium precipitation SOC, an SOC corresponding to a point at which the second curve first has a negative slope; and
method 2 comprises:
performing a first-order differential on the first curve to obtain a second curve,
performing a second-order differential on the second curve to obtain a third curve, and
determining, as the lithium precipitation SOC, an SOC corresponding to a point at which the third curve first has a vertical coordinate less than zero.

9. The electrochemical apparatus management method according to claim 1, wherein the intermittent charge operation comprises multiple charge periods, each charge cycle comprises a charge period and an interruption period, and in each charge cycle, SOC of the electrochemical apparatus increases by a unit amplitude.

10. The electrochemical apparatus management method according to claim 9, wherein the electrochemical apparatus comprises at least one of lithium iron phosphate system electrochemical apparatus, lithium nickel manganese cobalt system electrochemical apparatus, or lithium cobalt system electrochemical apparatus, wherein
in a case that the electrochemical apparatus is a lithium iron phosphate system electrochemical apparatus, the unit amplitude ranges from 0.5% to 10%, and a duration of the interruption period ranges from 1 second to 15 seconds;
in a case that the electrochemical apparatus is a lithium nickel manganese cobalt system electrochemical apparatus, the unit amplitude ranges from 0.5% to 10%, and a duration of the interruption period ranges from 1 second to 30 seconds; or
in a case that the electrochemical apparatus is a lithium cobalt system electrochemical apparatus, the unit amplitude ranges from 0.5% to 10%, and a duration of the interruption period ranges from 1 second to 30 seconds.

11. The electrochemical apparatus management method according to claim 10, wherein the method satisfies any one of conditions (a) to (f):
(a) in a case that the electrochemical apparatus is a lithium iron phosphate system electrochemical apparatus and the electrochemical apparatus is at an ambient temperature of -10°C to 10°C, the unit amplitude ranges from 0.5% to 10%, and a duration of the interruption period ranges from 5 seconds to 15 seconds;
(b) in a case that the electrochemical apparatus is a lithium iron phosphate system electrochemical apparatus and the electrochemical apparatus is at an ambient temperature of 10°C to 45°C, the unit amplitude ranges from 0.5% to 10%, and a duration of the interruption period ranges from 1 second to 10 seconds;
(c) in a case that the electrochemical apparatus is a lithium nickel manganese cobalt system electrochemical apparatus and the electrochemical apparatus is at an ambient temperature of -10°C to 10°C, the unit amplitude ranges from 0.5% to 10%, and a duration of the interruption period ranges from 10 seconds to 30 seconds;
(d) in a case that the electrochemical apparatus is a lithium nickel manganese cobalt system electrochemical apparatus and the electrochemical apparatus is at an ambient temperature of 10°C to 45°C, the unit amplitude ranges from 0.5% to 10%, and a duration of the interruption period ranges from 1 second to 10 seconds;
(e) in a case that the electrochemical apparatus is a lithium cobalt system electrochemical apparatus and the electrochemical apparatus is at an ambient temperature of -10°C to 10°C, the unit amplitude ranges from 0.5% to 10%, and a duration of the interruption period ranges from 15 seconds to 30 seconds; or
(f) in a case that the electrochemical apparatus is a lithium cobalt system electrochemical apparatus and the electrochemical apparatus is at an ambient temperature of 10°C to 45°C, the unit amplitude ranges from 0.5% to 10%, and a duration of the interruption period ranges from 1 second to 10 seconds.

12. The electrochemical apparatus management method according to claim 1, wherein the risk control operation comprises at least one of the following: reducing a charge voltage of the electrochemical apparatus, reducing a charge current of the electrochemical apparatus, performing staged charge on the electrochemical apparatus, or generating risk reminder information.

13. A system, comprising a processor and a machine-readable storage medium, wherein the machine-readable storage medium stores a machine-executable instruction capable of being executed by the processor, and when the processor executes the machine-executable instruction, the method according to any one of claims 1 to 12 is implemented.

14. An electrochemical apparatus, wherein the electrochemical apparatus comprises the system according to claim 13.

15. An electronic device, wherein the electronic device comprises the electrochemical apparatus according to claim 14.
